# EUROPEAN PATENT SPECIFICATION

(11) **EP 0 384 971 B1**
(45) Date of publication and mention of the grant of the patent: **18.05.1994**
(21) Application number: 89122329.9
(22) Date of filing: 04.12.1989
(51) Int. Cl.: B23K 35/00, H01L 21/90

(54) **Barrier disk**
Sperrscheibe
Disque de barrière

(30) Priority: 28.02.1989 US 316740
(43) Date of publication of application: 05.09.1990
(73) Proprietor: ROCKWELL INTERNATIONAL CORPORATION, El Segundo California 90245 (US)
(72) Inventor: Slemmons, John Whittier, Orange California 92669 (US); Woolston, Francis John, Santa Ana California 92701 (US); Redmond, Patrick Jordan, Fullerton California 92633 (US)
(74) Representative: Wagner, Karl H., Dipl.-Ing.

(56) References cited:
- DE-B- 2 312 724
- FR-A- 1 279 399
- GB-A- 1 198 257
- GB-A- 1 360 213
- US-A- 3 436 806
- US-A- 3 689 232
- IBM TECHNICAL DISLCOSURE BULLETIN, vol. 30, no. 7, December 1987, page 279, NewYork, US; "Enhanced aluminium wire bond process"

## Description

This invention relates to apparatus and methods for bonding a wire to a substrate, the wire and the substrate consisting of different materials, and has particular reference to bonding a wire to a substrate in such a fashion as to maintain good electrical conductivity between the wire and the substrate, and as to maintain this electrical conductivity in the presence of adverse environmental conditions.

### Background Art

US-A-3,689,232 relates to joint or jointing materials useful to eason jointing-by-welding of pipes, rods or plates of carbon steel or stainless steel with pipes, rods or plates of aluminium. In accordance with the teaching of said reference a joint for joining steel and aluminium comprises a multi-layer plate having layers of steel, titanium and aluminium, the titanium being positioned intermediate the layers of steel and aluminium and the bonds between the titanium and steel layers and the titanium and aluminium layers having been formed by explosive welding. Not only a three layers structure but also a 5-layer-clad can be provided such as carbon steel-stainless steel-titanium-pure-aluminium-corrosion resistance aluminium.

Semiconductor chips are generally formed with aluminium metallization. The boards upon which they are mounted, however, generally have conductive paths screened on them which are essentially made of gold. When a chip needs to be connected to a substrate on the board, it is necessary to have an aluminum/gold interface. When this happens, the aluminum and the gold react with each other, especially at higher temperatures. This causes two problems. First, the resistance of the junction becomes excessively great. Second, the mechanical strength of the junction becomes excessively small allowing the wire to work loose and cause an open circuit under forces which must be anticipated in its operating environment, and which would not cause such an open circuit if the junction were stronger.

Two possible solutions to this problem are to make an entirely aluminum apparatus, or an entirely gold apparatus. The former is not satisfactory, since the aluminum tracings on the board react with moisture and other environmental conditions, and rapidly attain an excessively higher resistance. The latter is equally unsatisfactory, if for no other reason than excessive cost.

### Summary of Invention

It is an objective of the present invention to overcome these problems by providing a region for bonding a wire to a substrate as claimed in claim 1 and by further providing a method as set forth in claims 9 and 17 for forming such a region. Preferred embodiments of the invention are disclosed in the dependent claims.

Two materials are "reactive" within the meaning of the present invention if they are sufficiently reactive as to cause a juncture between the materials to exceed a design limitation, such as resistance or strength; they are "nonreactive" if they do not.

In one embodiment of the present invention, each of the first and second materials comprises a first common element, and each of the fourth and fifth materials comprises a second common element. This first common element preferably comprises gold, and the second common element preferably comprises aluminum. Alternatively, the first common element may comprise aluminum, and the second common element comprise gold. This would be appropriate in the comparatively rare situation in which a gold wire is to be attached to an aluminum substrate.

The middle, second foil, which consists of a material which is nonreactive with both the first foil and with the third foil, may be made of a material comprising tungsten, nichrome, nickel, or platinum.

Such a bonding region may conveniently be formed by bonding together the first foil, the second foil, and the third foil (disposing the second foil between the first and third foils), and then bonding the first foil to the substrate. The composition of the foils, the substrate and the wire, is as described in the foregoing summary of the apparatus. A suitable method of bonding together the first and second foils comprises sputter deposition, either of the first foil upon the second, or the second foil upon the first. Likewise, sputter deposition may be used to bond the second foil onto the third, or the third onto the second.

Once such a three-foil combination has been formed, it may be conveniently bonded to the substrate by facing the first foil to the substrate and then placing the bonded together first, second, and third foils on the substrate. Alternatively, the bonded together foils may be placed, not on, but sufficiently close to the substrate that the foils maintain their integrity if they are pressed to the substrate in a region sufficient large as to accommodate the subsequent bonding of the wire to the third foil, but no larger. Once situated in this position, the foils are pressed to the substrate in a region sufficiently large as to accommodate the subsequent bonding of the wire to the third foil, and sufficient force is applied to the region of the foils as to bond the first foil to the substrate. The foils exclusive of the bond region may then be removed from the substrate.

The bonding process ideally takes place at an elevated temperature, and includes the application of ultrasound to the region of the foils, or both. Such ultrasound may conveniently applied to the foils through a stylus pressing the region of the foils to the substrate.

It is a feature of the present invention that the foils may readily be bonded to one another before the foil combination is bonded to the substrate or the wire.

It is an advantage of the present invention that the foil combination may be produced under conditions which might adversely affect the substrate, the board upon which the substrate rests, the wire, or the chip to which the wire leads.

### Brief Description of the Drawings

Figure 1 is a top plan view of a vacuum chamber in which the three-foil combination is formed by sputter deposition.

Figure 2 is a vertical cross section, partly schematic, of apparatus for sputter depositing tungsten and gold on an aluminum foil, taken along the line 2-2 shown in Figure 1.

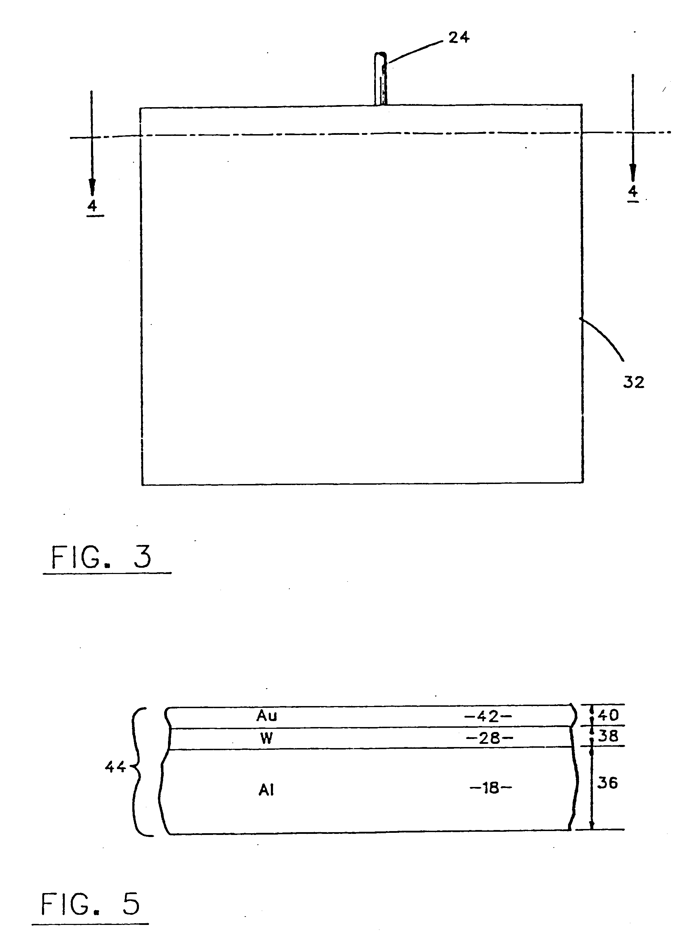

Figure 3 is a side elevation of the vacuum chamber shown in Figure 1.

Figures 4a, 4b, and 4c are top plan views of the vacuum chamber shown in Figure 3, taken along the line 4-4 shown in Figure 3. Figure 4a shows bombardment of the tungsten target. Figure 4b shows reversal of the tungsten and gold targets. Figure 4c shows bombardment of the gold target.

Figure 5 is a vertical cross-sectional schematic representation of the aluminum foil with the tungsten and gold foils sputter deposited on it.

Figure 6 is a vertical cross section of the three-foil combination, positioned to be bonded to the gold substrate by a stylus.

Figure 7 is a vertical cross section of the stylus bonding the three-foil combination to the substrate.

Figure 8 is a vertical cross section of the bond region remaining on the substrate after the stylus, and the portion of the foil exclusive of the bond region, have been removed.

### Preferred Embodiment For Carrying Out The Invention

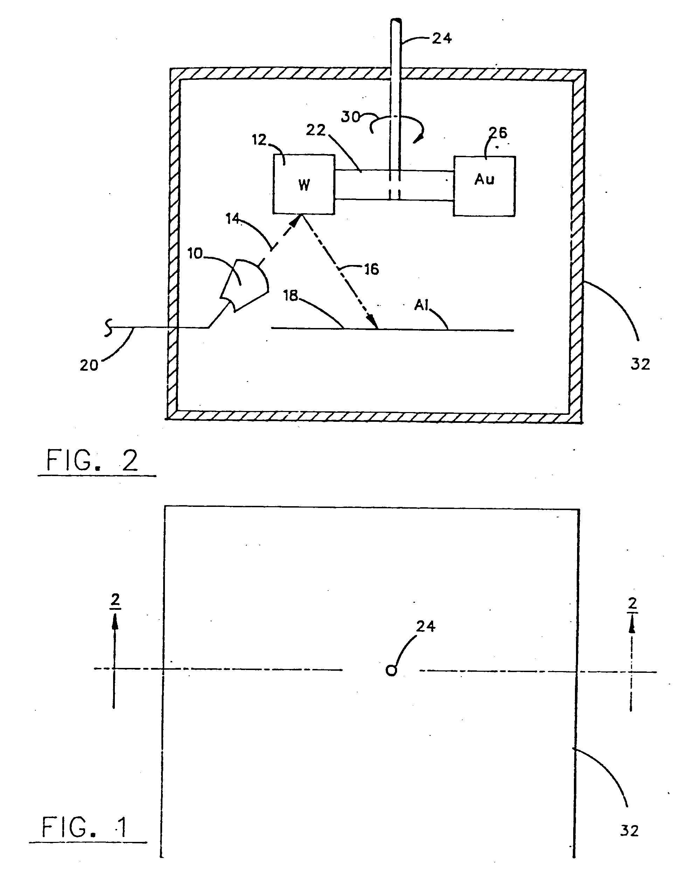

Turning now to Figure 2, sputter deposition takes place between an anode 10 and a tungsten cathode 12. Heavy ions 14 bombard the cathode 12, and sputter deposit tungsten atoms 16 upon an aluminum foil 18. Power is supplied to the anode 10 through a wire 20. As the ions 14 fall upon the cathode 12 and release their charge, the charge is removed from the cathode 12 by a horizontal support 22, which is connected both electrically and mechanically with a vertical support 24. The excess charge falling upon the cathode 12 is therefore withdrawn along horizontal support 22 and vertical support 24.

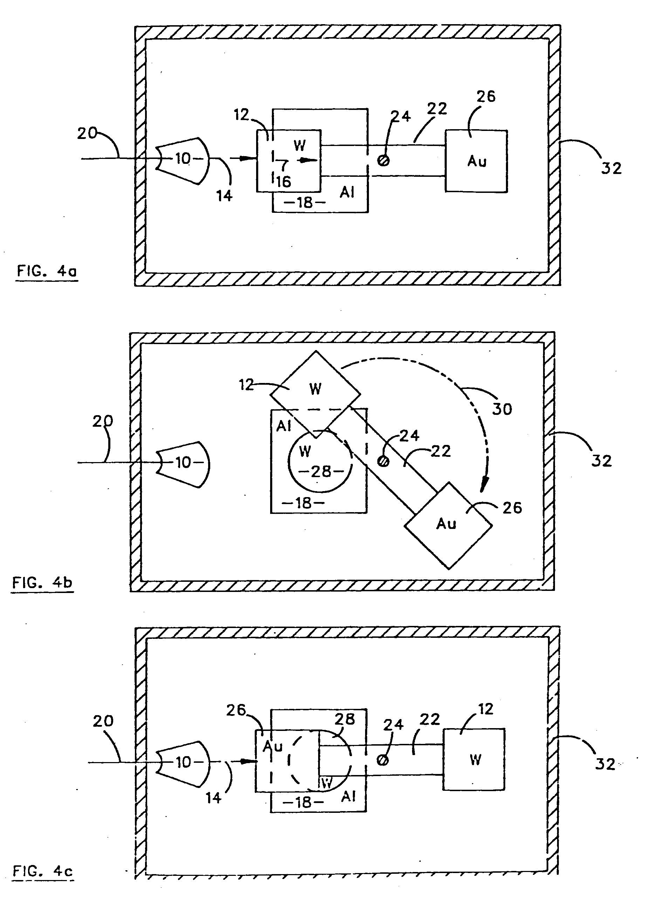

The tungsten cathode 12 may be rotated away from the trajectory of the ions 14, and a gold cathode 26 may be placed in the trajectory of the ions 14 in the place of the tungsten cathode 12. This is best seen in Figure 4a, which shows a top plan view of the ions 14 bombarding the tungsten target 12, with the tungsten atoms 16, blocked from view by the tungsten target 12, being shown in phantom line.

When a sufficiently thick layer 28 of tungsten has formed on the aluminium foil 18, power is withdrawn from the wire 20 and vertical support 24, and the horizontal support 22 is rotated by the vertical support 24 so as to place the gold cathode 26 in the trajectory of the ions 14 (Figure 4b). The power is then turned back on, and gold is deposited over the tungsten layer 28 (Figure 4c). In Figure 4b, the direction of rotation of the horizontal bar 22 is shown by the arrow 30, although either direction may be used.

The apparatus is maintained within a vacuum vessel 32, so that air will not interfere with the path of the ions 14 or of the tungsten atoms 16 (Figure 4a) or of the gold atoms 34 (Figure 4c). Placing both targets 12, 26 within a single vacuum vessel 32 allows the entire three-foil structure to be produced without breaking the vacuum to change targets.

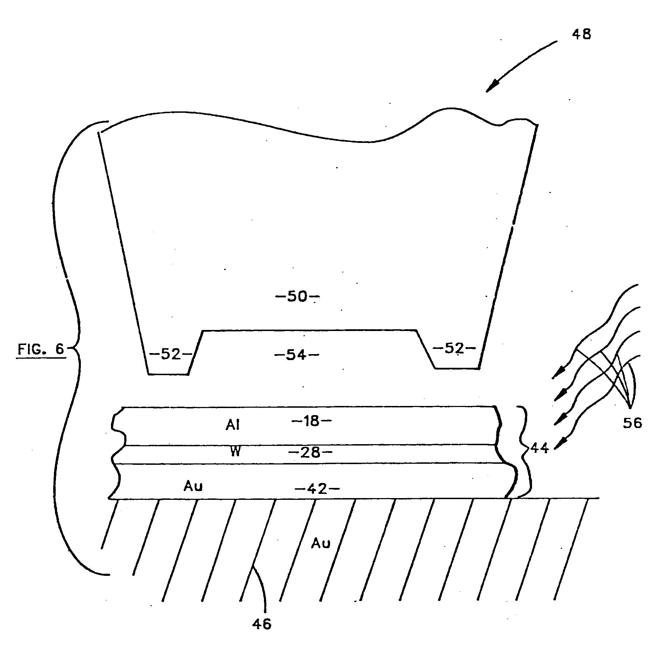

As shown in Figure 5, the aluminum foil 18 has a thickness 36 which is greater than the thickness 38 of the tungsten sputter deposited layer 28, or the thickness 40 of the gold sputter deposited layer 42. Applicants prefer to use a 7 mil (0.007 inch) aluminum foil 18, a 1,500Å unit tungsten layer 28, and a 5,000Å unit gold layer 42. The tungsten 28 need only be thick enough to prevent reaction between the gold 42 and the aluminum 18. As tungsten is a fairly brittle metal, excess thickness is not desired.

It is apparent from the foregoing dimensions that Figure 5 is not drawn to scale, but is an essentially schematic representation of the three-foil combination, drawn to maximize comprehension of the present invention.

Aluminum is used as the foil upon which the tungsten and gold are sputter deposited because it is cheap and easily worked. Other materials with these characteristics, and with the appropriate nonreactivity, may also be used.

Similarly, it is not required that the foil which bonds to the wire be the foil upon which the others are sputter deposited. In applications other than the embodiment shown herein, it may be more advantageous for the central foil to be the one upon which the others are sputter deposited, one on each side, or for the foil which bonds to the substrate to be the one upon which the others are sputter deposited.

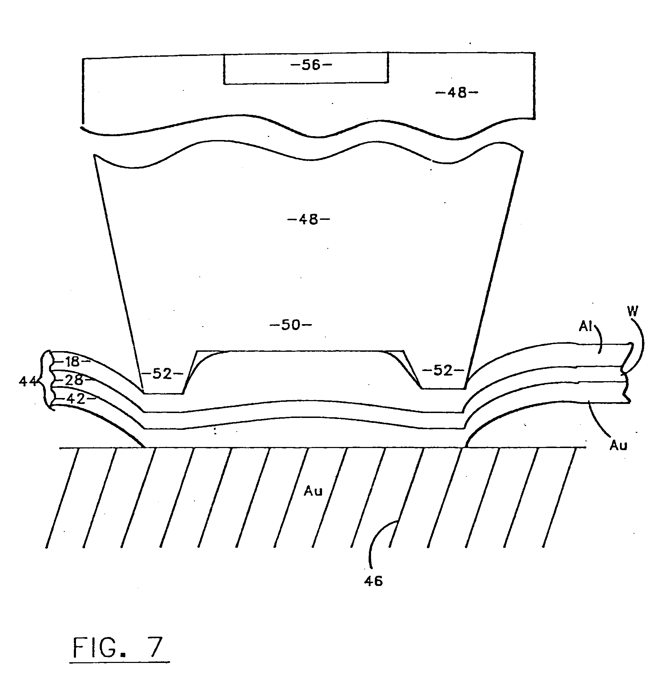

The gold, tungsten, and aluminum foils 42, 28, 18 form a three-foil combination 44, which, after being removed from the vacuum vessel 32, is then inverted and placed over a gold substrate 46. The inversion is performed to assure that the gold layer 42 faces the gold substrate 46, while the aluminum layer 18 will face upward. As shown in Figure 6, a stylus 48 is positioned to press the three-foil combination 44 against the substrate 46. The point 50 of the stylus 48 has a protruding circular rim 52, and a circular central recess 54.

The three-foil combination 44 and substrate 46 are then heated, preferably to around 150 C, with energy 56.

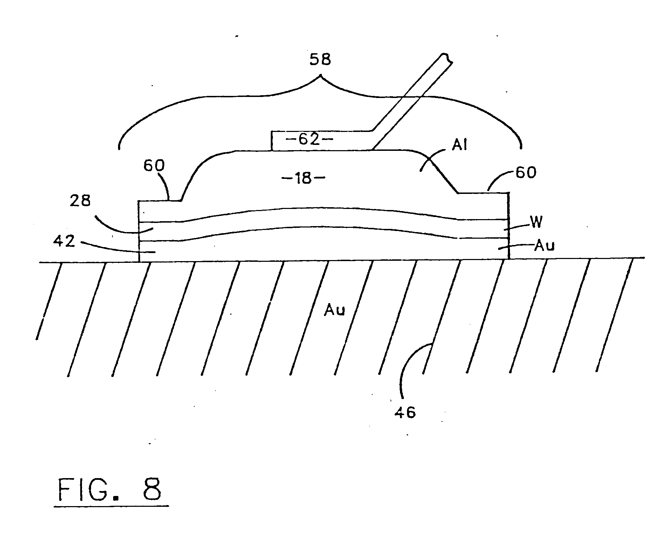

Turning now to Figure 7, the stylus 48 presses the three-foil combination 44 against the substrate 46. The three-foil combination 44 is maintained close enough to the substrate 46 that the combination 44 maintains its integrity as it is pressed against the substrate 46. Once pressed against the substrate 46, the three-foil combination 44 is subjected to ultrasound transmitted through the stylus 48 from a piezoelectric crystal 56. The combination of the ultrasound, preferably at about 60 kHz, with the elevated temperatures causes the region 58 (see Figure 8) of the three-foil combination 44 to bond to the gold substrate 46. This bond region 58 may also be called a barrier disk.

The recess 54 in the tip 50 of the stylus 48 (Figure 6) is sufficiently shallow that sufficient force is applied even to the center of the region 58 as to bond it to the substrate 46. At the same time, the recess 54 is not so shallow that the rim 52 is unable to bond the edge 60 (Figure 8) of the region 58 even more tightly to the substrate 46, and, more importantly, to so compress the edge 60 as to weaken it. Once weakened, the three-foil combination 44 will tear at the edge 60, and may be removed while leaving the bond region 58 still firmly bonded to the substrate 46. The stylus 48 may be removed before, concurrently with, or after, the removal of the three-foil combination 44.

The invention is now complete. An aluminum wire 62 may now be bonded to the aluminum foil portion 18 of the bond region 58.

The tungsten layer 28 may be replaced with a comparable layer of nichrome, nickel, platinum, or any other conductive material which does not react with either aluminum or gold. Likewise, the aluminum layer 18 may be replaced with a layer of any other composition which does not read with the wire 62. This replacement will be especially appropriate if the composition of the wire 62 is changed. Similarly, the gold layer 42 may be replaced with a layer of any other material which does not react with the substrate 46. As with the wire 62, this replacement will be especially appropriate if the composition of the substrate 46 is changed. If either or both substitutions arc made, the tungsten layer 28 may have to be replaced by a layer of some other material which does not react with either the layer 18 interfacing with the wire 62, or the layer 42 interfacing with the substrate 46.

The radius of the barrier disk 58 thus formed should be large enough to accommodate the wire 62, but should not be much larger, or excessive portions of the substrate 46 will be covered. If desired, however, the barrier disk 58 may be made large enough to accommodate several wires 62, rather than providing a separate disk 58 for each dire 62.

Once chips have been bonded to a board, and the gold substrate 46 screened onto the board, the connection of the chips to the substrate may be readily automated. The three-foil combination 44 may be stretched across the entire board, and the board and the foil heated to the desired temperature. The stylus 48 may then be successively pressed against the substrate, and a brief burst of ultrasound applied to the stylus 48, in the desired locations. When barrier disks 58 have been formed at all the desired locations, the foil combination 44, with as many holes in it as there are barrier disks 58, may then be removed. Aluminum wires 62 may then be bonded between the aluminum metallized chips and the barrier disks 58 using any convenient technology.

### Industrial Applicability

The present invention is capable of exploitation in industry, and may be used, whenever it is desired to bond a wire to a dissimilar substrate. It may be made by bonding together foils of any three suitably nonreactive material, wherein the nonreactivity is both with respect to the foil or foils which each foil contacts, and with respect to the wire or substrate, as appropriate.

While a particular embodiment of the present invention has been described above, the true scope of the present invention is not defined thereby, but by the claims which are appended hereto.

## Claims

1. A region (58) for bonding a wire (62) to a substrate (46), the substrate consisting of a first material, the region comprising:
(a) a first foil (42) bonded to the substrate (46), and consisting of a second material which is nonreactive with the first material;
(b) a second foil (28) formed on the first foil (42) by sputter deposition, or upon which the first foil is formed by sputter deposition, said second foil consisting of a third material which is nonreactive with the second material;
(c) a third foil (60) formed on the second foil (28) by sputter deposition, or upon which the second foil is formed by sputter deposition, said third foil consisting of a fourth material which is nonreactive with the third material;
wherein the wire to be bonded to the substrate consists of a fifth material which is reactive with the first material but nonreactive with the fourth material.

2. The bond region of claim 1, wherein each of the first and second materials comprises a first common element, and wherein each of the fourth and fifth materials comprises a second common element.

3. The bond region of claim 2, wherein the first common element comprises gold and the second common element comprises aluminium.

4. The bond region of claim 2, wherein the first common element comprises aluminium and the second common element comprises gold.

5. The bond region of any of claims 1 to 4, wherein the third material comprises tungsten.

6. The bond region of any of claims 1 to 4, wherein the third material comprises nichrome.

7. The bond region of any of claims 1 to 4, wherein the third material comprises nickel.

8. The bond region of any of claims 1 to 4, wherein the third material comprises platinum.

9. A method for forming a region for bonding a wire to a substrate, the substrate consisting of a first material, the method comprising:
(a) forming a second foil (28) on a first foil (42), or the first foil (42) on the second foil (28), by sputter deposition; and forming a third foil (60) on the second foil (28), or the second foil (28) on the third foil, by sputter deposition,
the second foil (28) being disposed between the first foil (42) and the third foil (60),
the first foil (42) consisting of a second material which is nonreactive with the first material,
the second foil (28) consisting of a third material which is nonreactive with the second material, and the third foil (60) consisting of a fourth material which is nonreactive with the third material; and
(b) bonding the first foil to the substrate;
the wire (62) consisting of a fifth material which is reactive with the first material but nonreactive with the fourth material.

10. The method of claim 9, wherein each of the first and second materials comprises a first common element, and wherein each of the fourth and fifth materials comprises a second common element.

11. The method of claim 9, wherein the first common element comprises gold and the second common element comprises aluminium.

12. The method of claim 9, wherein the first common element comprises aluminium and the second common element comprises gold.

13. The method of any of the claims 9 to 12, wherein the third material comprises tungsten.

14. The method of any of the claims 9 to 12, wherein the third material comprises nichrome.

15. The method of any of the claims 9 to 12, wherein the third material comprises nickel.

16. The method of any of the claims 9 to 12, wherein the third material comprises platinum.

17. The method of forming the bond region of any of claims 1 to 8, the method comprising:
(a) facing the first foil to the substrate;
(b) placing the bonded together first, second, and third foils on the substrate or sufficiently close to the substrate that the foils maintain their integrity if they are pressed to the substrate in a region sufficiently large as to accommodate the subsequent bonding of the wire to the third foil, but no larger;
(c) pressing the foils to the substrate in a region sufficiently large as to accomodate the subsequent bonding of the wire to the third foil;
(d) applying sufficient force to region of the foils as to bond the first foil to the substrate; and
(e) removing the foils from the substrate exclusive of the bond region.

18. The method of claim 17, further comprising the step elevating the temperature of the substrate, the region of the foils, or both the substrate and the region of the foils.

19. The method of claim 17, further comprising the step of applying ultrasound to the region of the foils.

20. The method of claim 19, wherein the ultrasound is applied to the foils through a stylus pressing the region of the foils to the substrate.

21. The method of claim 19, further comprising the step elevating the temperature of the substrate, the region of the foils, or both the substrate and the region of the foils.

22. The method of claim 21, wherein the ultrasound is applied to the foils through a stylus pressing the region of the foils to the substrate.

## Patentansprüche

1. Ein Bereich (58) zum Verbinden bzw. Bondieren eines Drahtes (62) mit einem Substrat (46), wobei das Substrat aus einem ersten Material besteht, wobei der Bereich folgendes aufweist:
(a) eine erste Folie (42), die mit dem Substrat (46) verbunden bzw. bondiert ist und aus einem zwei ten Material besteht, das mit dem ersten Material nicht reagiert bzw. nicht reaktiv ist;
(b) eine zweite Folie (28), die auf der ersten Folie (42) gebildet, durch Sputterablagerung oder Kathodenzerstäubung, oder auf der die erste Folie durch Sputterablagerung gebildet ist, wobei die zweite Folie aus einem dritten Material besteht, das mit dem zweiten Material nicht reagiert bzw. nicht reaktiv ist;
(c) eine dritte Folie (60), die auf der zweiten Folie (28) gebildet ist durch Sputterablagerung, oder auf der die zweite Folie gebildet ist durch Sputterablagerung, wobei die dritte Folie aus einem vierten Material besteht, das mit dem dritten Material nicht reagiert bzw. nicht reaktiv ist;
wobei der mit dem Substrat zu verbindende Draht aus einem fünften Material besteht, das mit dem ersten Material reagiert bzw. reaktiv ist, aber mit dem vierten Material nicht reagiert bzw. nicht reaktiv ist.

2. Verbindungs- oder Bondierungsbereich gemäß Anspruch 1, wobei jedes der ersten und zweiten Materialien ein erstes gemeinsames Element aufweist, und wobei jedes der vierten und fünften Materialien ein zweites gemeinsames Element aufweist.

3. Verbindungs- bzw. Bondierungsbereich gemäß Anspruch 2, wobei das erste gemeinsame Element Gold aufweist und wobei das zweite gemeinsame Element Aluminium aufweist.

4. Verbindungs-bzw. Bondierungsbereich gemäß Anspruch 2, wobei das erste gemeinsame Element Aluminium aufweist und wobei das zweite gemeinsame Element Gold aufweist.

5. Verbindungs- bzw. Bondierungsbereich gemäß einem der Ansprüche 1 bis 4, wobei das dritte Material Wolfram aufweist.

6. Verbindungs- bzw. Bondierungsbereich gemäß einem der Ansprüche 1 bis 4, wobei das dritte Material Nichrom aufweist.

7. Verbindungs- bzw. Bondierungsbereich gemäß einem der Ansprüche 1 bis 4, wobei das dritte Material Nickel aufweist.

8. Verbindungs- bzw. Bondierungsbereich gemäß einem der Ansprüche 1 bis 4, wobei das dritte Material Platin aufweist.

9. Verfahren zum Bilden eines Bereichs zum Verbinden bzw. Bondieren eines Drahts mit einem Substrat, wobei das Substrat aus einem ersten Material besteht, wobei das Verfahren folgendes aufweist:
(a) Bilden einer zweiten Folie (28) auf einer ersten Folie (42), oder der ersten Folie (42) auf der zweiten Folie (28), und zwar durch Sputterablagerung oder Kathodenzerstäubung; und Bilden einer dritten Folie (60) auf der zweiten Folie (28), oder der zweiten Folie (28) auf der dritten Folie, und zwar durch Sputterablagerung,
wobei die zweite Folie (28) zwischen der ersten Folie (22) und der dritten Folie (60) angeordnet ist,
wobei die erste Folie (42) aus einem zweiten Material besteht, das mit dem ersten Material nicht reagiert bzw. nicht reaktiv ist,
wobei die zweite Folie (28) aus einem dritten Material besteht, das mit dem zweiten Material nicht reagiert bzw. nicht reaktiv ist, und
wobei die dritte Folie (60) aus einem vierten Material besteht, das mit dem dritten Material nicht reagiert bzw. nicht reaktiv ist; und
(b) Verbinden bzw. Bondieren der ersten Folie mit dem Substrat;
wobei der Draht (62) aus einem fünften Material besteht, das mit dem ersten Material reagiert bzw. reaktiv ist, aber mit dem vierten Material nicht reagiert bzw. nicht reaktiv ist.

10. Verfahren gemäß Anspruch 9, wobei jedes der ersten und zweiten Materialien ein erstes gemeinsames Element aufweist, und wobei jedes der vierten und fünften Materialien ein zweites gemeinsames Element aufweist.

11. Verfahren gemäß Anspruch 9, wobei das erste gemeinsame Element Gold aufweist und wobei das zweite gemeinsame Element Aluminium aufweist.

12. Verfahren gemäß Anspruch 9, wobei das erste gemeinsame Element Aluminium aufweist und wobei das zweite gemeinsame Element Gold aufweist.

13. Verfahren gemäß einem der Ansprüche 9 bis 12, wobei das dritte Material Wolfram aufweist.

14. Verfahren gemäß einem der Ansprüche 9 bis 12, wobei das dritte Material Nichrom aufweist.

15. Verfahren gemäß einem der Ansprüche 9 bis 12, wobei das dritte Material Nickel aufweist.

16. Verfahren gemäß einem der Ansprüche 9 bis 12, wobei das dritte Material Platin aufweist.

17. Verfahren zum Bilden des Verbindungs- bzw. Bondierungsbereichs gemäß einem der Ansprüche 1 bis 8, wobei das Verfahren folgendes aufweist:
(a) Richten der ersten Folie auf das Substrat;
(b) Anordnen der miteinander verbundenen bzw. bondierten ersten, zweiten und dritten Folien auf dem Substrat oder ausreichend nahe zu dem Substrat, das die Folien ihre Unversehrtheit oder Integrität beibehalten, wenn sie auf das Substrat gedrückt werden in einem Bereich, der ausreichend groß ist, jedoch nicht größer ist, daß das darauffolgende Verbinden bzw. Bondieren des Drahts mit der dritten Folie berücksichtigt oder aufgenommen wird;
(c) Pressen der Folien auf das Substrat in einem Bereich, der ausreichend groß ist, um das nachfolgende Verbinden bzw. Bondieren des Drahts mit der dritten Folie zu berücksichtigen oder aufzunehmen;
(d) Anlegen einer ausreichenden Kraft auf den Bereich der Folien, um die erste Folie mit dem Substrat zu verbinden bzw. zu bondieren ; und
(e) Entfernen der Folien von dem Substrat mit Ausnahme des Verbindungs- bzw. Bondierungsbereichs.

18. Verfaren gemäß Anspruch 17, wobei das Verfahren ferner den Schritt aufweist des Anhebens der Temperatur des Substrats, des Bereichs der Folien, oder sowohl des Substrats als auch des Bereichs der Folien.

19. Verfahren gemäß Anspruch 17, wobei das Verfahren ferner den Schritt aufweist des Anlegens von Ultraschall an den Bereich der Folien.

20. Verfahren gemäß Anspruch 19, wobei der Ultraschall an die Folien angelegt wird durch einen Stylus, der den Bereich der Folien an das Substrat drückt.

21. Verfahren gemäß Anspruch 19, wobei das Verfahren ferner den Schritt aufweist des Anhebens der Temperatur des Substrats, des Bereichs der Folien, oder des Substrats und des Bereichs der Folien.

22. Verfahren gemäß Anspruch 21, wobei der Ultraschall an die Folien angelegt wird durch einen Stylus, der den Bereich der Folien an das Substrat drückt.

## Revendications

1. Région (58) de liaison d'un fil métallique (62) à un substrat (46), le substrat étant constitué d'un premier matériau, la région comprenant :
(a) une première feuille (42) fixée au substrat (46) et constituée d'un second matériau qui ne réagit pas avec le premier matériau,
(b) une seconde feuille (28) formée sur la première feuille (42) par dépôt par pulvérisation ou sur laquelle la première feuille est formée par dépôt par pulvérisation, la seconde feuille étant constituée d'un troisième matériau qui ne réagit pas avec le second, et
(c) une troisième feuille (60) formée sur la seconde feuille (28) par dépôt par pulvérisation ou sur laquelle la seconde feuille est formée par dépôt par pulvérisation, la troisième feuille étant constituée d'un quatrième matériau qui ne réagit pas avec le troisième matériau, et
le fil métallique destiné à être lié au substrat est constitué d'un cinquième matériau qui réagit avec le premier matériau mais qui ne réagit pas avec le quatrième matériau.

2. Région de liaison de la figure 1, dans laquelle chacun des premier et second matériaux comporte un premier élément commun, et dans laquelle chacun des quatrième, cinquième matériaux comporte un second élément commun.

3. Région de liaison selon la revendication 2, dans laquelle le premier élément commun est l'or et le second élément commun est l'aluminium.

4. Région de liaison selon la revendication 1, dans laquelle le premier élément commun est l'aluminium et le second élément commun est l'or.

5. Région de liaison selon l'une quelconque des revendications 1 à 4, dans laquelle le troisième matériau est le tungstène.

6. Région de liaison selon l'une quelconque des revendications 1 à 4, dans laquelle le troisième matériau est le "Nichrome".

7. Région de liaison selon l'une quelconque des revendications 1 à 4, dans laquelle le troisième matériau est le nickel.

8. Région de liaison selon l'une quelconque des revendications 1 à 4, dans laquelle le troisième matériau est le platine.

9. Procédé de formation d'une région de liaison d'un fil métallique à un substrat, le substrat étant constitué d'un premier matériau, le procédé comprenant :
(a) la formation d'une seconde feuille (28) sur une première feuille (42), ou de la première feuille (42) sur la seconde feuille (28), par dépôt par pulvérisation, et la formation d'une troisième feuille (60) sur la seconde feuille (28) ou de la seconde feuille (28) sur la troisième feuille par dépôt par pulvérisation,
la seconde feuille (28) étant placée entre la première feuille (42) et la troisième feuille (60),
la première feuille (42) étant constituée d'un second matériau qui ne réagit pas avec le premier matériau,
la seconde feuille (28) étant formée d'un troisième matériau qui ne réagit pas avec le second matériau, et la troisième feuille (60) étant constituée d'un quatrième matériau qui ne réagit pas avec le troisième matériau, et
(b) la liaison de la première feuille au substrat, le fil métallique (62) étant constitué d'un cinquième matériau qui peut réagir avec le premier matériau mais qui ne réagit pas avec le quatrième matériau.

10. Procédé selon la revendication 9, dans lequel chacun des premier et second matériaux comporte un premier élément commun, et chacun des quatrième et cinquième matériaux comporte un second élément commun.

11. Procédé selon la revendication 9, dans lequel le premier élément commun est l'or et le second élément commun est l'aluminium.

12. Procédé selon la revendication 9, dans lequel le premier élément commun est l'aluminium et le second élément commun est l'or.

13. Procédé selon l'une quelconque des revendications 9 à 12, dans lequel le troisième matériau est le tungstène.

14. Procédé selon l'une quelconque des revendications 9 à 12, dans lequel le troisième matériau est le "Nichrome".

15. Procédé selon l'une quelconque des revendications 9 à 12, dans lequel le troisième matériau est le nickel.

16. Procédé selon l'une quelconque des revendications 9 à 12, dans lequel le troisième matériau est le platine.

17. Procédé de formation de la région de liaison selon l'une quelconque des revendications 1 à 8, le procédé comprenant :
(a) la mise de la première feuille en face du substrat,
(b) la disposition de la première, la seconde et la troisième feuille, qui sont liées, sur le substrat ou suffisamment près du substrat pour que les feuilles conservent leur intégrité lorsqu'elles sont repoussées vers le substrat dans une région suffisamment grande pour permettre la liaison ultérieure du fil à la troisième feuille, mais pas excessivement grande,
(c) l'application des feuilles par pression contre le substrat dans une région suffisamment grande pour qu'elle permette la liaison ultérieure du fil métallique à la troisième feuille,
(d) l'application d'une force suffisante à la région des feuilles pour que la première feuille soit liée au substrat, et
(e) l'extraction des feuilles du substrat en dehors de la région de liaison.

18. Procédé selon la revendication 17, comprenant en outre l'étape d'élévation de la température du substrat, de la région des feuilles ou à la fois du substrat et de la région des feuilles.

19. Procédé selon la revendication 17, comprenant en outre une étape d'application d'ultrasons à la région des feuilles.

20. Procédé selon la revendication 19, dans lequel les ultrasons sont appliqués aux feuilles par un style appliquant la région des feuilles contre le substrat.

21. Procédé selon la revendication 19, comprenant en outre une étape d'élévation de la température du substrat, de la région des feuilles ou à la fois du substrat et de la région des feuilles.

22. Procédé selon la revendication 21, dans lequel les ultrasons sont appliqués aux feuilles par un style repoussant la région des feuilles contre le substrat.
